# EUROPEAN PATENT APPLICATION

(11) **EP 4 844 112 A1**
(43) Date of publication of application: **25.11.2026**
(21) Application number: 26752360.3
(22) Date of filing: 04.02.2026
(51) Int. Cl.: C30B 29/24, C23C 14/08, C23C 14/34

(54) **METHOD FOR PRODUCING MULTILAYERED STRUCTURE**

(30) Priority: 04.02.2025 JP 2025017080
(71) Applicant: ULVAC, Inc., Chigasaki-shi, Kanagawa 253-8543 (JP)
(72) Inventor: KOBAYASHI, Hiroki, Chigasaki-shi, Kanagawa 253-8543 (JP); TSUYUKI, Tatsuro, Chigasaki-shi, Kanagawa 253-8543 (JP); USHIYAMA, Fumitada, Chigasaki-shi, Kanagawa 253-8543 (JP)
(74) Representative: Zacco GmbH
(86) International application number: PCT/JP2026/003978
(87) International publication number: WO 2026/168483

(57) **Abstract**

A method of manufacturing a multilayer structure includes a first epitaxial deposition step of forming, by sputtering, a first layer oriented in the (100) plane on the (100) surface of a silicon substrate, a second epitaxial deposition step of forming, by sputtering, a second layer of Pt oriented in the (100) plane on the first layer, and a third epitaxial deposition step of forming, by sputtering, a third layer oriented in the (100) plane on the second layer.

## Description

### TECHNICAL FIELD

The present invention relates to a method of manufacturing a multilayer structure.

Priority is claimed on Japanese Patent Application No. 2025-017080, filed on February 4, 2025, the content of which is incorporated herein by reference.

### BACKGROUND ART

Pure zirconia (Pure-ZrO₂) normally has a monoclinic crystal structure. In order to obtain a cubic crystal structure, it is necessary to use yttria-stabilized zirconia (YSZ).

Patent Document 1 describes a technology for growing a cubic crystal film using YSZ. In the disclosure of Patent Document 1, in order to grow Pt or SrRuO₃ on the (100) plane over a YSZ layer, a ceria (CeO₂) film is interposed between ZrO₂ and an upper layer and is oriented with a 45° in-plane rotation, and epitaxial growth is performed parallel to the Si <110> direction.

Patent Document 2 describes that, by using ZrO₂, Pt can be oriented in the (100) plane and epitaxially grown parallel to Si <100> without using CeO₂.

### Citation List

### Patent Document

Patent Document 1: Japanese Unexamined Patent Application, First Publication No. 2005-005450
Patent Document 2: United States Patent No. 11785854

### SUMMARY OF INVENTION

### Technical Problem

However, in the technology disclosed in Patent Document 1, the number of layers increases and therefore the technology is not preferable for mass production technology.

Also, in the technology disclosed in Patent Document 2, ZrO₂ normally has a monoclinic crystal structure, and compared to a vapor deposition method in which the kinetic energy is 10⁻¹ eV to 10⁻² eV, the kinetic energy in a sputtering method is as high as 10² eV to 10³ eV. For this reason, strain tends to occur in the film, and it is difficult to obtain a cubic crystal with Pure-ZrO₂. The technology disclosed in Patent Document 2 is not preferable because it requires two different chambers, namely one for performing vapor deposition and another for performing sputtering.

The present invention has been made in view of the above circumstances and aims to achieve the following objectives.
1. To enable all depositions to be performed by sputtering, and to enable manufacturing by a continuous in-situ deposition.
2. To enable manufacture of a film oriented in the same direction as the silicon substrate.
3. To reduce the number of steps and improve manufacturing efficiency.

### Solution to Problem

Piezoelectric elements using a ferroelectric material such as lead zirconate titanate (Pb(Zr,Ti)O₃: PZT) are known. Such piezoelectric elements are applied in devices such as inkjet heads, micromirrors, gyro sensors, piezoelectric micromachined ultrasonic transducers (PMUTs), vibration elements, acoustic wave elements, and acceleration sensors in microelectromechanical systems (MEMS) technologies. Among these, PZT films have attracted attention.

It is known that there is a preferable figure of merit (e_{31, f})²/ε [GPa] in each device using PZT. A range of the figure of merit varies depending on the device. The figure of merit (e_{31, f})²/ε [GPa] is defined by the piezoelectric constant e_{31, f} [C/m²] and the relative permittivity εᵣ. Here, depending on the device, there is a demand to increase the piezoelectric constant while decreasing the permittivity. In such a case, the figure of merit cannot be improved unless both conditions are satisfied. To this end, it is preferable to epitaxially grow a PZT film having a tetragonal composition and a c-axis orientation.

Here, it is generally difficult to obtain a tetragonal PZT-based thin film with c-axis orientation by epitaxial growth on a Si substrate. The reason is said to be due to a difference in thermal expansion coefficients between Si and PZT, and it is known that the film preferentially orients along the a-axis.

In the technique disclosed in Patent Document 1, the crystal orientation of the PZT film is rotated, and it cannot be grown in the same direction as Si.

Also, there has been a demand to enable epitaxial growth of the tetragonal PZT-based thin film while reducing the number of laminations. At the same time, there has been a demand to enable continuous in-situ deposition processing and improve throughput.

Through intensive research, the present inventors have found, for the first time in a sputtering method, a method of orienting Pt in the (100) direction and achieving epitaxial growth parallel to Si <100> without using CeO₂.

Furthermore, in a fabrication of a PZT epitaxial film suitable for devices such as sensors, it has become possible to provide a process that enables continuous in-situ processing of all steps by sputtering.

A method of manufacturing a multilayer structure according to one aspect of the present invention solves the above-described problems by the following steps.

A method of manufacturing a multilayer structure according to one aspect of the present invention includes a first epitaxial deposition step of forming, by sputtering, a first layer oriented in the (100) plane on the (100) surface of a silicon substrate, a second epitaxial deposition step of forming, by sputtering, a second layer of Pt oriented in the (100) plane on the first layer, and a third epitaxial deposition step of forming, by sputtering, a third layer oriented in the (100) plane on the second layer.

The first epitaxial deposition step is any one of:
a step of etching a surface of the silicon substrate and a step of depositing YSZ as the first layer at a temperature of 700°C or higher to have a thickness of 200 nm to 500 nm,
a step of depositing YSZ as the first layer at a temperature of 650°C or higher to have a thickness of 200 nm to 500 nm without removing silicon oxide on the surface of the silicon substrate,
a step of depositing a Zr seed layer at a temperature of 400°C or higher to have a thickness of 1.5 nm to 3.5 nm without removing silicon oxide on the surface of the silicon substrate and a step of depositing YSZ as the first layer on the seed layer at a temperature of 650°C or higher to have a thickness of 200 nm to 500 nm, or
a step of depositing a Zr seed layer at a temperature of 400°C or higher to have a thickness of 1.5 nm to 3.5 nm without removing silicon oxide on the surface of the silicon substrate and a step of depositing YSZ as the first layer on the seed layer at a temperature of 650°C or higher to have a thickness of 18 nm to 67 nm.

In other words, the first epitaxial deposition step includes any one of the following first to fourth steps.

The first step includes the step of etching a surface of the silicon substrate and the step of depositing YSZ as the first layer at a temperature of 700°C or higher to have a thickness of 200 nm to 500 nm.

The second step includes the step of depositing YSZ as the first layer at a temperature of 650°C or higher to have a thickness of 200 nm to 500 nm without removing silicon oxide on the surface of the silicon substrate.

The third step includes the step of depositing a Zr seed layer at a temperature of 400°C or higher to have a thickness of 1.5 nm to 3.5 nm without removing silicon oxide on the surface of the silicon substrate and the step of depositing YSZ as the first layer on the seed layer at a temperature of 650°C or higher to have a thickness of 200 nm to 500 nm.

The fourth step includes the step of depositing a Zr seed layer at a temperature of 400°C or higher to have a thickness of 1.5 nm to 3.5 nm without removing silicon oxide on the surface of the silicon substrate and the step of depositing YSZ as the first layer on the seed layer at a temperature of 650°C or higher to have a thickness of 18 nm to 67 nm.

A method of manufacturing a multilayer structure according to one aspect of the present invention includes a first epitaxial deposition step of forming, by sputtering, a first layer oriented in the (100) plane on the (100) surface of a silicon substrate, a second epitaxial deposition step of forming, by sputtering, a second layer of Pt oriented in the (100) plane on the first layer, and a third epitaxial deposition step of forming, by sputtering, a third layer oriented in the (100) plane on the second layer. The first epitaxial deposition step includes depositing YSZ as the first layer to have a thickness of 25 nm to 50 nm, and the second epitaxial deposition step includes a step of depositing Pt as the second layer at a temperature of 500°C or higher.

In the method of manufacturing a multilayer structure according to one aspect of the present invention, the third layer may be SrRuO₃ or LaNiO₃ in the third epitaxial deposition step.

The method of manufacturing a multilayer structure according to one aspect of the present invention may further include a fourth epitaxial deposition step of forming, by sputtering, a PZT layer oriented in the (100) plane on the third layer after the third epitaxial deposition step.

In the method of manufacturing a multilayer structure according to one aspect of the present invention, the PZT layer may be doped with lanthanum and nickel in the fourth epitaxial deposition step.

A method of manufacturing a multilayer structure according to one aspect of the present invention includes a first epitaxial deposition step of forming, by sputtering, a first layer oriented in the (100) plane on the (100) surface of a silicon substrate, a second epitaxial deposition step of forming, by sputtering, a second layer of Pt oriented in the (100) plane on the first layer, and a third epitaxial deposition step of forming, by sputtering, a third layer oriented in the (100) plane on the second layer.

According to the method described above, all layers can be manufactured by continuous in-situ sputtering, and all layers can be stacked and grown with the same plane orientation. As a result, it becomes possible to obtain a Pt layer that is epitaxially grown and oriented in the same (100) plane as that of silicon, which was not possible conventionally. Therefore, when a PZT layer is formed on the Pt layer, it is possible to manufacture an epitaxial PZT film having a tetragonal composition and oriented in a predetermined direction. Film properties of the PZT film can be improved, the number of steps can be reduced, and manufacturing efficiency can be improved.

In the method of manufacturing a multilayer structure according to one aspect of the present invention, the first epitaxial deposition step includes any one of the first to fourth steps described above.

According to the method described above, by selecting any one of the first to fourth steps as conditions for the first epitaxial deposition step, it is possible to obtain a cubic YSZ film allowing deposition of a Pt layer oriented in the (100) plane by epitaxial growth. Particularly, even when X-ray scans such as a ϕ-scan and a 20 scan are performed, side peaks other than (100) do not appear; that is, a YSZ film oriented in the (100) plane can be obtained.

Here, YSZ is ZrO₂ doped with Y₂O₃, that is, Y-ZrO₂. Particularly, when a seed layer is used, it is preferable to perform rapid thermal anneal (RTA) heat treatment after depositing metallic zirconium by sputtering. Also, the seed layer is not particularly limited in terms of whether it is integrated with the first layer as a multilayer structure or can be detected separately.

In the method of manufacturing a multilayer structure according to one aspect of the present invention, the first epitaxial deposition step includes depositing YSZ as the first layer to have a thickness of 25 nm to 50 nm, and the second epitaxial deposition step includes a step of depositing Pt as the second layer at a temperature of 500°C or higher.

According to the above-described method, when the above-described conditions are selected for the first epitaxial deposition step and the second epitaxial deposition step, it is possible to form a Pt layer that is single-oriented in the (100) plane over the entire deposition surface. When a PZT layer is formed on the Pt layer, it is possible to manufacture an epitaxial PZT film having a tetragonal composition and oriented in a predetermined direction. Film properties of the PZT film can be improved, the number of steps can be reduced, and manufacturing efficiency can be improved.

In the method of manufacturing a multilayer structure according to one aspect of the present invention, the third layer in the third epitaxial deposition step is SrRuO₃ or LaNiO₃.

According to the above-described method, the third layer (buffer layer) is formed on the (100)-oriented Pt. Therefore, all layers can be deposited by continuous in-situ sputtering, and an epitaxial PZT film having a tetragonal composition and a c-axis orientation can be stacked and grown. Moreover, in the PZT layer, a piezoelectric constant e_{31, f} [C/m²] can be set to 10.0 to 11.9, a dielectric loss can be set to 1.0% to 1.8%, and a relative permittivity can be set to 200 to 375 [dimensionless].

Here, a thickness of the SrRuO₃ film is preferably 15 nm to 25 nm.

The method of manufacturing a multilayer structure according to one aspect of the present invention further includes a fourth epitaxial deposition step of forming, by sputtering, a PZT layer oriented in the (100) plane on the third layer after the third epitaxial deposition step.

According to the above-described method, when a continuous in-situ process is performed up to the fourth epitaxial deposition step, in deposition of the PZT layer oriented in the (100) plane, the piezoelectric constant e_{31, f} [C/m²] can be set to 10.0 to 11.9, the dielectric loss can be set to 1.0% to 1.8%, and the relative permittivity can be set to 200 to 375 [dimensionless].

Here, in the fourth epitaxial deposition step, the deposition of the PZT layer is preferably performed at a temperature of 575°C to 650°C.

In the method of manufacturing a multilayer structure according to one aspect of the present invention, the PZT layer is doped with lanthanum and nickel in the fourth epitaxial deposition step.

According to the above-described method, tensile internal stress can be significantly reduced. Therefore, it is possible to suppress occurrence of cracks in the PZT layer and provide a PZT film suitable for practical use.

Here, as impurities doped into the PZT layer, it is preferable that at least one of lanthanum (La) and nickel (Ni) be doped into the PZT layer in an amount of 0.1 [at%] or more and 5 [at%] or less.

### Advantageous Effects of Invention

According to the present invention, it is possible to provide a method of manufacturing a multilayer structure that can improve manufacturing efficiency by reducing the number of steps, realize all film depositions by sputtering, and manufacture a PZT film by continuous in-situ deposition. Furthermore, a multilayer structure with improved film properties can be provided.

### BRIEF DESCRIPTION OF DRAWINGS

[FIG. 1] A schematic cross-sectional view showing a multilayer structure according to a first embodiment of the present invention.
[FIG. 2] A flowchart showing a method of manufacturing the multilayer structure according to the first embodiment of the present invention.
[FIG. 3] A schematic plan view showing a manufacturing apparatus used in the method of manufacturing the multilayer structure according to the first embodiment of the present invention.
[FIG. 4A] A diagram showing shapes of X-ray diffraction peaks of respective layers constituting the multilayer structure according to the first embodiment of the present invention.
[FIG. 4B] A diagram showing shapes of X-ray diffraction peaks of respective layers constituting the multilayer structure according to the first embodiment of the present invention.
[FIG. 4C] A diagram showing shapes of X-ray diffraction peaks of respective layers constituting the multilayer structure according to the first embodiment of the present invention.
[FIG. 5A] A diagram showing shapes of X-ray diffraction peaks of respective layers constituting the multilayer structure according to the first embodiment of the present invention.
[FIG. 5B] A diagram showing shapes of X-ray diffraction peaks of respective layers constituting the multilayer structure according to the first embodiment of the present invention.
[FIG. 5C] A diagram showing shapes of X-ray diffraction peaks of respective layers constituting the multilayer structure according to the first embodiment of the present invention.
[FIG. 6] A diagram showing a relationship between a thickness of a YSZ layer and a presence or absence of a (111) side peak in X-ray diffraction in the multilayer structure according to the first embodiment of the present invention.
[FIG. 7] A diagram showing a relationship between a thickness of the YSZ layer and a presence or absence of a (111) side peak in X-ray diffraction in the multilayer structure according to the first embodiment of the present invention.
[FIG. 8] A diagram showing a relationship among a thickness of the YSZ layer, a deposition temperature of a Pt layer, and an orientation direction of Pt in X-ray diffraction in the multilayer structure according to the first embodiment of the present invention.
[FIG. 9] A diagram showing X-ray diffraction peaks of the YSZ layer.
[FIG. 10] A diagram showing X-ray diffraction peaks of the YSZ layer in the multilayer structure according to the first embodiment of the present invention.
[FIG. 11] A diagram showing X-ray diffraction peaks of the YSZ layer shown in FIG. 10.
[FIG. 12] A diagram showing X-ray diffraction peaks of a silicon substrate on which the YSZ layer shown in FIG. 10 is deposited.
[FIG. 13] A diagram showing X-ray diffraction peaks of the PZT layer in the multilayer structure according to the first embodiment of the present invention.
[FIG. 14] A diagram showing X-ray diffraction peaks of the PZT layer in the multilayer structure according to the first embodiment of the present invention.
[FIG. 15] A diagram showing X-ray diffraction peaks of the PZT layer shown in FIG. 14.
[FIG. 16] A diagram showing an internal stress distribution of the PZT layer in the multilayer structure according to the first embodiment of the present invention.
[FIG. 17] A diagram showing a surface observation result of the PZT layer shown in FIG. 16.
[FIG. 18] A diagram showing an internal stress distribution of the PZT layer.
[FIG. 19] A diagram showing a surface observation result of the PZT layer shown in FIG. 18.
[FIG. 20] A diagram showing a relative permittivity of the PZT layer in the multilayer structure according to the first embodiment of the present invention.
[FIG. 21] A diagram showing a dielectric loss of the PZT layer in the multilayer structure according to the first embodiment of the present invention.
[FIG. 22] A diagram showing a piezoelectric constant e_{31, f} of the PZT layer in the multilayer structure according to the first embodiment of the present invention.
[FIG. 23] A diagram showing a figure of merit of the PZT layer in the multilayer structure according to the first embodiment of the present invention.
[FIG. 24] A diagram showing X-ray diffraction peaks of a PZT layer in a multilayer structure according to a second embodiment of the present invention.
[FIG. 25] A diagram showing X-ray diffraction peaks of the PZT layer in the multilayer structure according to the second embodiment of the present invention.
[FIG. 26] A diagram showing X-ray diffraction peaks of the PZT layer shown in FIG. 25.
[FIG. 27] A diagram obtained by analyzing, by X-ray diffraction, changes in the PZT layer due to changes in deposition temperature in the multilayer structure according to the present embodiment.

### DESCRIPTION OF EMBODIMENTS

Hereinafter, a method of manufacturing a multilayer structure and the multilayer structure according to a first embodiment of the present invention will be described with reference to the drawings.

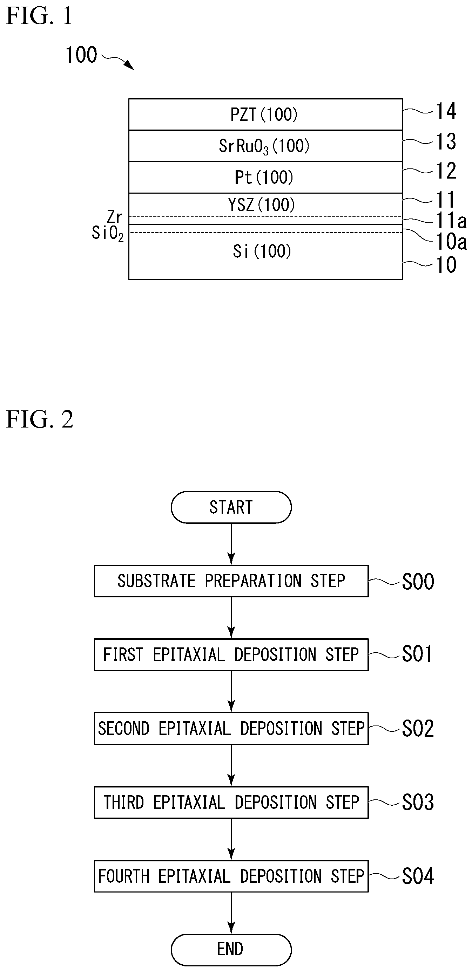

FIG. 1 is a schematic cross-sectional view showing the multilayer structure of the present embodiment. In the drawing, reference numeral 100 denotes the multilayer structure.

As shown in FIG. 1, the multilayer structure 100 according to the present embodiment has a structure including a first layer 11, a second layer 12, a third layer 13, and a fourth layer 14 which are stacked on a silicon substrate 10.

The silicon substrate 10 is a silicon single-crystal substrate. The (100) plane of the silicon substrate 10 is a lamination surface. The (100) plane of the silicon substrate 10 corresponds to a "surface of the silicon substrate". A lattice constant of silicon is 5.431 angstroms.

The first layer 11 is deposited on the silicon substrate 10. The first layer 11 contains zirconium. The first layer 11 is yttria-stabilized zirconia (YSZ; ZrO₂ doped with Y₂O₃; Y-ZrO₂). The (100) plane of the first layer 11 is oriented in the (100) plane with respect to the Si (100) plane. The first layer 11 has the same orientation as the (100) plane of the silicon substrate 10. A lattice constant of YSZ is 5.139 angstroms.

The second layer 12 is deposited on the first layer 11. The second layer 12 is a platinum (Pt) layer. The second layer 12 is oriented in the (100) plane with respect to the (100) plane of the first layer 11. The (100) plane of the second layer 12 is oriented parallel to the YSZ (100) plane. The (100) plane of the second layer 12 has the same orientation as the (100) planes of the silicon substrate 10 and the first layer 11. A lattice constant of Pt is 3.920 angstroms.

The third layer 13 is deposited on the second layer 12. The third layer 13 is a buffer layer. The third layer 13 is a buffer layer. The third layer 13 is a strontium ruthenate (SRO; SrRuO₃) film. The third layer 13 is oriented in the (100) plane with respect to the (100) plane of the second layer 12. The (100) plane of the third layer 13 is oriented parallel to the Pt (100) plane. The (100) plane of the third layer 13 has the same orientation as the (100) planes of the silicon substrate 10, the first layer 11, and the second layer 12. A lattice constant of SrRuO₃ is 3.930 angstroms.

The fourth layer 14 is deposited on the third layer 13. The fourth layer 14 is a PZT layer. The fourth layer 14 is a lead zirconate titanate (Pb(Zr,Ti)O₃: PZT) film having a tetragonal composition and a c-axis orientation. The fourth layer 14 is a PZT film doped with lanthanum (La) and/or nickel (Ni) as impurities in an amount of 0.1 [at%] or more to 5 [at%] or less. The fourth layer 14 is oriented in the (100) plane with respect to the (100) plane of the third layer 13. The (100) plane of the fourth layer 14 has the same orientation as the (100) planes of the silicon substrate 10, the first layer 11, the second layer 12, and the third layer 13. A lattice constant of PZT is approximately 3.9 angstroms which is the same as a lattice constant of a typical simple perovskite oxide.

In the multilayer structure 100 according to the present embodiment, the first layer 11, the second layer 12, and the third layer 13 are laminated on the silicon substrate 10. When the fourth layer 14 is laminated on the third layer 13, a PZT layer having the piezoelectric constant e_{31, f} [C/m²] and the dielectric constant ε [F/m], which are within predetermined ranges can be obtained.

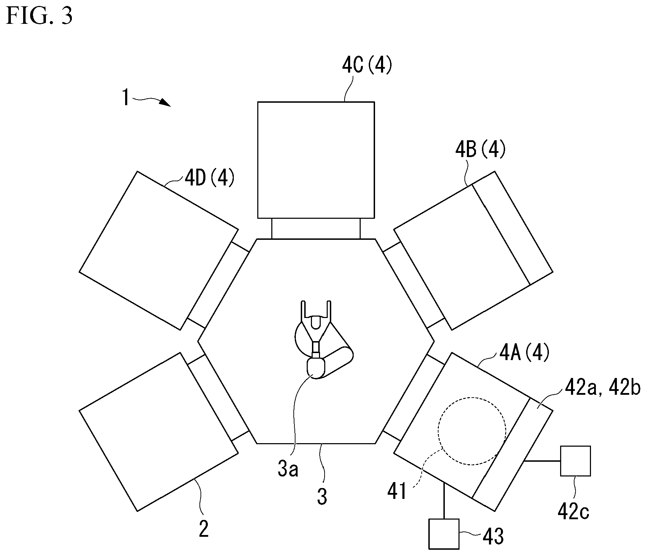

FIG. 2 is a flowchart showing a method of manufacturing the multilayer structure of the present embodiment. FIG. 3 is a schematic plan view showing a manufacturing apparatus used in the method of manufacturing the multilayer structure in the present embodiment.

As shown in FIG. 2, the method of manufacturing the multilayer structure according to the present embodiment includes substrate preparation step S00, a first epitaxial deposition step S01 for depositing the first layer 11, a second epitaxial deposition step S02 for depositing the second layer 12, a third epitaxial deposition step S03 for depositing the third layer 13, and a fourth epitaxial deposition step S04 for depositing the fourth layer 14.

In substrate preparation step S00, the silicon substrate 10 made of single-crystal silicon is prepared. Here, the (100) plane of the silicon substrate 10 is defined as a lamination surface. As will be described later, different surface treatments are performed on the silicon substrate 10 depending on conditions in the first epitaxial deposition step S01. That is, as a surface treatment of the silicon substrate 10, an etching process for removing a native oxide film can be performed. Alternatively, a state in which the native oxide film is not removed may be maintained. Note that, regardless of whether or not the native oxide film is removed, a surface cleaning treatment may be performed. In this case, a treatment such as an etching treatment may be selected as the cleaning treatment.

In the first epitaxial deposition step S01, the first layer 11 is epitaxially deposited on a lamination surface of the silicon substrate 10. The first epitaxial deposition step S01 performs deposition using a manufacturing apparatus 1 shown in FIG. 3.

As shown in FIG. 3, the manufacturing apparatus 1 (sputtering apparatus) includes a load/unload chamber 2, a plurality of deposition chambers 4 (chambers), and a transfer chamber 3 positioned between the deposition chambers 4 and the load/unload chamber 2 (chamber). In the example shown in FIG. 3, four deposition chambers are shown. The four deposition chambers include a first deposition chamber 4A, a second deposition chamber 4B, a third deposition chamber 4C, and a fourth deposition chamber 4D. In the description of these deposition chambers, when the plurality of deposition chambers do not need to be distinguished from each other, or when one deposition chamber is described, it may simply be referred to as the deposition chamber 4.

The manufacturing apparatus 1 is a vacuum processing apparatus. The manufacturing apparatus 1 can perform sputtering deposition on the silicon substrate 10 in each deposition chamber 4. In the manufacturing apparatus 1, a plurality of chambers constituting the load/unload chamber 2 and the plurality of deposition chambers 4 are disposed to surround the transfer chamber 3. In the manufacturing apparatus 1, a gate valve is formed between each of the plurality of chambers and the transfer chamber 3. The manufacturing apparatus 1 is capable of moving the silicon substrate 10 among the load/unload chamber 2, the plurality of deposition chambers 4, and the transfer chamber 3 while maintaining a vacuum-reduced pressure sealed state.

The load/unload chamber 2 is a load chamber for loading the silicon substrate 10 from the outside toward the inside of the manufacturing apparatus 1. The load/unload chamber 2 is also an unload chamber for unloading the silicon substrate 10 from the inside of the manufacturing apparatus 1 to the outside. The load/unload chamber 2 is configured to be usable for both loading and unloading operations of the silicon substrate 10. Note that, a plurality of load/unload chambers 2 may be disposed in the manufacturing apparatus 1. In this case, each of the plurality of load/unload chambers 2 independently performs the loading and unloading operations of the silicon substrate 10.

A positioning member capable of alignment by setting a placement position of the silicon substrate 10 loaded from the outside of the manufacturing apparatus 1 may be disposed in the load/unload chamber 2.

The load/unload chamber 2 is provided with a roughing exhaust device (a roughing exhaust device, a low-vacuum evacuation device) such as a rotary pump for evacuating the interior to a rough vacuum.

The transfer chamber 3 is provided with a roughing exhaust device (a roughing exhaust device, a low-vacuum evacuation device) such as a rotary pump for evacuating the interior to a rough vacuum. A transfer device 3a (transfer robot) is disposed inside the transfer chamber 3.

The transfer device 3a includes a rotation shaft, a robot arm attached to the rotation shaft, a robot hand formed at one end of the robot arm, and a vertical movement device for moving the robot hand vertically. The robot arm is constituted by a first active arm, a second active arm, a first driven arm, and a second driven arm that are bendable with respect to one another. The transfer device 3a is capable of moving the silicon substrate 10, which is an object to be transferred, between each of the plurality of chambers (the load/unload chamber 2 and the plurality of deposition chambers 4) and the transfer chamber 3.

Each of the plurality of deposition chambers 4 has a configuration capable of performing sputtering deposition. The plurality of deposition chambers 4 may all have the same configuration. However, each of the plurality of deposition chambers 4 is configured to process separately in accordance with a plurality of different deposition steps. Hereinafter, a case will be described in which each of the plurality of deposition chambers 4 of the manufacturing apparatus 1 has a configuration corresponding to the first epitaxial deposition step S01 to the fourth epitaxial deposition step S04, but the configuration of the manufacturing apparatus 1 is not limited to the configuration described below.

Note that, the deposition steps performed by the plurality of deposition chambers 4 may be different from each other. As will be described later, it may be configured such that different deposition steps are processed in the same chamber by, for example, replacing a target.

Note that, any one of the plurality of deposition chambers 4 may have a configuration capable of performing processes other than sputtering deposition such as, for example, an etching process, a heat treatment process, or substrate treatment process in a predetermined gas atmosphere.

One deposition chamber 4 includes a substrate holding mechanism 41, a deposition mechanism 42, and a gas atmosphere adjustment mechanism 43. Note that, the substrate holding mechanism 41, the deposition mechanism 42, and the like are schematically shown in FIG. 3, and are not particularly limited by the drawing.

The substrate holding mechanism 41 receives the silicon substrate 10 transferred by the transfer device 3a. The substrate holding mechanism 41 holds the silicon substrate 10 inside the deposition chamber 4. The substrate holding mechanism 41 is capable of transferring the silicon substrate 10 inside the deposition chamber 4. The substrate holding mechanism 41 transfers the silicon substrate 10 to the transfer device 3a.

The substrate holding mechanism 41 holds the silicon substrate 10 to face a target 42a of the deposition mechanism 42 during deposition. The substrate holding mechanism 41 is capable of setting a distance between the silicon substrate 10 and the deposition mechanism 42 during deposition. The substrate holding mechanism 41 is capable of applying bias power to the silicon substrate 10 during deposition. The substrate holding mechanism 41 has a temperature control unit capable of setting a temperature of the silicon substrate 10 during deposition.

The temperature control unit includes a heating member built therein and a heating power supply. As the heating member, for example, SiC is used. The heating member may be disposed below the silicon substrate 10. The temperature control unit may include a cooling unit. For example, it may be configured such that a temperature-controlled cooling medium circulates inside the cooling unit.

The deposition mechanism 42 is disposed inside the deposition chamber 4. The deposition mechanism 42 performs epitaxial deposition processing. The deposition mechanism 42 supplies a deposition material in the epitaxial deposition processing.

The deposition mechanism 42 includes the target 42a, a cathode electrode 42b (backing plate), and a power supply 42c.

The target 42a supplies a deposition material corresponding to the deposition step using the target 42a. The target 42a is fabricated into a predetermined shape according to a composition of a film to be deposited on a surface of the silicon substrate 10. The target 42a is disposed to face the silicon substrate 10 inside the deposition chamber 4. The target 42a is attached to the cathode electrode 42b.

The cathode electrode 42b is disposed at an upper part of the deposition chamber 4 via an insulating member. The cathode electrode 42b and a wall portion of the deposition chamber 4 are electrically insulated from each other. The wall portion of the deposition chamber 4 is at a ground potential. One surface side of the cathode electrode 42b is locally exposed to the inside of the deposition chamber 4. The target 42a is fixed in close contact with a central part of the exposed region on the one surface side of the cathode electrode 42b. The target 42a and the cathode electrode 42b are electrically connected to each other.

The power supply 42c (sputtering power supply) applies a sputtering voltage of a negative potential to the cathode electrode 42b. The power supply 42c is disposed outside the deposition chamber 4. The power supply 42c is electrically connected to the cathode electrode 42b, and the power supply 42c can apply an AC voltage to the target 42a via the cathode electrode 42b.

The gas atmosphere adjustment mechanism 43 includes a gas introduction mechanism and a high-vacuum evacuation mechanism. The gas introduction mechanism introduces, into the deposition chamber 4, a sputtering gas and a deposition gas corresponding to the deposition step in which the gas atmosphere adjustment mechanism 43 is used. The high-vacuum evacuation mechanism evacuates the inside of the deposition chamber 4. The high-vacuum evacuation mechanism is, for example, a turbo molecular pump or the like. The gas atmosphere adjustment mechanism 43 is capable of setting a pressure inside the deposition chamber 4 during deposition.

The deposition mechanism 42 may have a magnetron magnetic circuit. The magnetron magnetic circuit forms a predetermined magnetic field on the target 42a. The magnetron magnetic circuit is disposed on a side of the cathode electrode 42b opposite to the target 42a, that is, on the other surface side of the cathode electrode 42b.

The first epitaxial deposition step S01 is performed, for example, in the first deposition chamber 4A in FIG. 3. In this case, plasma processing such as etching is possible in the first deposition chamber 4A. Also, in the first deposition chamber 4A, the target 42a has a composition capable of epitaxially depositing the first layer 11. The target 42a may be a single target made of yttria-stabilized zirconia. Alternatively, the target 42a may be a plurality of targets including a target containing zirconium oxide or zirconia and a target containing yttrium or the like.

In this case, in the first deposition chamber 4A, the gas atmosphere adjustment mechanism 43 sets a gas atmosphere and a pressure range required for deposition conditions. At the same time, the deposition mechanism 42 sets required deposition power. Also, the substrate holding mechanism 41 sets a required deposition temperature and bias power.

In the first epitaxial deposition step S01, the inside of the first deposition chamber 4A is depressurized by the gas atmosphere adjustment mechanism 43, and thereafter vacuum evacuation is continued to maintain a vacuum atmosphere inside the first deposition chamber 4A.

Then, Ar gas is introduced as a sputtering gas from the gas atmosphere adjustment mechanism 43 into the first deposition chamber 4A. At the same time, high frequency (negative high-frequency power) is applied from the power source 42c to the cathode electrode 42b to cause the cathode electrode 42b to discharge. As a result, plasma of the Ar gas introduced into the deposition chamber 4 is generated and positive ions such as Ar ions are produced, thereby forming a plasma space. The positive ions in the formed plasma space sputter the target 42a held by the cathode electrode 42b. Constituent elements of the sputtered target 42a are emitted from the target 42a and are sputter-deposited on the (100) plane of the silicon substrate 10 held by the substrate holding mechanism 41, in a neutral or ionized state.

Specifically, the first epitaxial deposition step includes any one of the following first to fourth steps.

### [First step]

The first step includes a step of etching a surface of the silicon substrate 10, and a step of epitaxially depositing YSZ (ZrO₂ doped with Y₂O₃; Y-ZrO₂) as the first layer 11 to have a thickness of 200 nm to 500 nm at a temperature of 700°C or higher.

In this case, in the etching step, a native oxide film 10a is removed by, for example, a dry etching process using plasma or the like. Alternatively, the native oxide film 10a may be removed in advance by a wet etching process, and then a dry etching process using plasma or the like may be performed. Regarding YSZ deposition conditions in this case, 100% Ar gas may be used as the supply gas, and 1500 W may be applied as plasma generation power.

### [Second step]

The second step includes a step of epitaxially depositing YSZ as the first layer **11** to have a thickness of 200 nm to 500 nm at a temperature of 650°C or higher without removing the silicon oxide 10a (native oxide film) on the surface of the silicon substrate 10.

In this case, YSZ is deposited while the native oxide film 10a remains. Regarding the YSZ deposition conditions in this case, 100% Ar gas may be used as the supply gas, and 1500 W may be applied as the plasma generation power.

In this case, after the YSZ is deposited, an RTA process may be performed in a vacuum at a processing temperature of 650°C. After the RTA process, the native oxide film 10a is integrated with the YSZ of the first layer 11. Alternatively, it is also possible to perform a process of forming silicon oxide on the surface of the silicon substrate 10 in advance.

### [Third step]

The third step includes a step of forming a Zr seed layer 11a to have a thickness of 1.5 nm to 3.5 nm at a temperature of 400°C or higher without removing the silicon oxide 10a on the surface of the silicon substrate 10, and a step of epitaxially depositing YSZ as the first layer 11 on the seed layer 11a to have a thickness of 200 nm to 500 nm at a temperature of 650°C or higher.

In this case, the seed layer 11a and the YSZ are formed while the native oxide film 10a remains. Regarding deposition conditions of the seed layer 11a in this case, metallic zirconium may be used as the target, 100% Ar gas may be used as the supply gas, and a plasma generation condition of 0.3 kW may be applied as the plasma generation power.

Regarding the YSZ deposition conditions in this case, YSZ ceramics may be used as the target, 100% Ar gas may be used as the supply gas, and 1500 W may be applied as the plasma generation power. In this case, after the YSZ is deposited, an RTA process at a processing temperature of 650°C may be performed in a vacuum. After the RTA process, the native oxide film 10a and the seed layer 11a are integrated with the YSZ of the first layer 11.

### [Fourth step]

The fourth step includes a step of forming the Zr seed layer 11a to have a thickness of 1.5 nm to 3.5 nm at a temperature of 400°C or higher without removing the silicon oxide 10a on the surface of the silicon substrate 10, and a step of forming YSZ as the first layer on the seed layer 11a to have a thickness of 18 nm to 67 nm at a temperature of 650°C or higher.

In this case, the seed layer 11a and the YSZ are formed while the native oxide film 10a remains. Regarding the deposition conditions of the seed layer 11a in this case, metallic zirconium may be used as the target, 100% Ar gas may be used as the supply gas, and the plasma generation condition of 0.3 kW may be applied as the plasma generation power.

Regarding the YSZ deposition conditions in this case, YSZ ceramics may be used as the target, 100% Ar gas may be used as the supply gas, and 1500 W may be applied as the plasma generation power. In this case, after the YSZ is deposited, an RTA process may be performed. After the RTA process, the native oxide film 10a and the seed layer 11a are integrated with the YSZ of the first layer 11.

When the deposition in the first epitaxial deposition step S01 ends, application of voltage from the power supply 42c to the cathode electrode 42b is stopped, and introduction of the sputtering gas from the gas atmosphere adjustment mechanism 43 into the deposition chamber 4 is stopped.

By the first epitaxial deposition step S01, the (100) plane of the first layer 11, which is YSZ having a cubic structure, can be deposited to be oriented in the <100> direction with respect to the (110) plane of the silicon substrate 10.

After deposition of the first layer 11 by the first epitaxial deposition step S01 ends, the silicon substrate 10 is moved to the second deposition chamber 4B via the transfer chamber 3.

In the second epitaxial deposition step S02, the second layer 12 is epitaxially deposited on the first layer 11. The second epitaxial deposition step S02 is, for example, similarly performed in the second deposition chamber 4B in FIG. 3. In this case, in the second deposition chamber 4B, the target 42a has a composition that enables epitaxial deposition of the second layer 12. In this case, the target 42a may be a single target made of platinum. Also, in this case, in the second deposition chamber 4B, the gas atmosphere adjustment mechanism 43 sets the gas atmosphere and the pressure range required for the deposition conditions. At the same time, the deposition mechanism 42 sets the required deposition power. Also, the substrate holding mechanism 41 sets the required deposition temperature and bias power. Regarding Pt deposition conditions in this case, Pt may be used as the target, 100% Ar gas may be used as the supply gas, and 0.5 kW may be applied as the plasma generation power.

The second epitaxial deposition step S02 includes a step of depositing Pt as the second layer at a temperature of 500°C or higher. At this time, in the first epitaxial deposition step S01, the first layer 11 can be deposited to have a thickness of 25 nm to 50 nm.

According to the above-described method, when the above-described conditions are selected for the first epitaxial deposition step and the second epitaxial deposition step, it is possible to form a Pt layer that is single-oriented in the (100) plane over the entire deposition surface. When a PZT layer is formed on the Pt layer, it is possible to manufacture an epitaxial PZT film having a tetragonal composition and oriented in a predetermined direction. Film properties of the PZT film can be improved, the number of steps can be reduced, and manufacturing efficiency can be improved.

By the second epitaxial deposition step S02, the (100) plane of the second layer 12, which is Pt having a cubic structure, can be deposited to be oriented in the <100> direction with respect to the (110) plane of the silicon substrate 10 and the (100) plane of the first layer 11 which is YSZ. The Pt (100) plane of the second layer 12 is not in-plane rotated with respect to the (100) plane of the first layer 11, which is YSZ, and the (110) plane of the silicon substrate 10.

After deposition of the second layer 12 by the second epitaxial deposition step S02 ends, the silicon substrate 10 is moved to the third deposition chamber 4C via the transfer chamber 3.

In the third epitaxial deposition step S03, the third layer 13 is epitaxially deposited on the second layer 12. The third epitaxial deposition step S03 is performed, for example, in the third deposition chamber 4C in FIG. 3. In this case, in the third deposition chamber 4C, the target 42a has a composition that enables epitaxial deposition of the third layer 13. In this case, the target 42a may be a single target made of strontium ruthenate (SRO; SrRuO₃). Alternatively, the strontium ruthenate may be deposited using a plurality of targets.

Also, in this case, in the third deposition chamber 4C, the gas atmosphere adjustment mechanism 43 sets the gas atmosphere and the pressure range required for the deposition conditions. At the same time, the deposition mechanism 42 sets the required deposition power. Also, the substrate holding mechanism 41 sets the required deposition temperature and bias power. Regarding Pt deposition conditions in this case, SrRuO₃ may be used as the target, Ar gas and O₂ gas may be used as the supply gases, and 1500 W may be applied as the plasma generation power.

Note that, a thickness of the third layer 13 is preferably approximately 20 nm, or in a range of 15 nm to 25 nm.

By the third epitaxial deposition step S03, the (100) plane of the third layer 13, which is SrRuO₃ having a cubic structure, can be deposited to be oriented in the <100> direction with respect to the (110) plane of the silicon substrate 10, the YSZ (100) plane of the first layer 11, and the Pt (100) plane of the second layer 12. The SrRuO₃ (100) plane of the third layer 13 is not in-plane rotated with respect to the SrRuO₃ (100) plane of the second layer 12, the YSZ (100) plane of the first layer 11, and the (110) plane of the silicon substrate 10.

After deposition of the third layer 13 by the third epitaxial deposition step S03 ends, the silicon substrate 10 is moved to the fourth deposition chamber 4D via the transfer chamber 3.

In the fourth epitaxial deposition step S04, the fourth layer 14, which is PZT, is epitaxially deposited on the third layer 13 serving as a buffer layer.

The fourth epitaxial deposition step S04 is performed, for example, in the fourth deposition chamber 4D in FIG. 3. In this case, in the fourth deposition chamber 4D, the target 42a has a composition that enables epitaxial deposition of the fourth layer 14. In this case, as the target 42a, a single target made of lead zirconate titanate [Pb(ZrₓTi₁₋ₓ)O₃ PZT] doped with lanthanum (La) and/or nickel (Ni) as impurities may be used. Alternatively, it may be configured such that a plurality of targets are used so that lead zirconate titanate doped with lanthanum (La) and/or nickel (Ni) as impurities is deposited.

Also, in this case, in the fourth deposition chamber 4D, the gas atmosphere adjustment mechanism 43 sets the gas atmosphere and the pressure range required for the deposition conditions. At the same time, the deposition mechanism 42 sets the required deposition power. Also, the substrate holding mechanism 41 sets the required deposition temperature and bias power. Regarding PZT deposition conditions in this case, PZT containing La/Ni may be used as the target, Ar/O₂ gas may be used as the supply gas, a deposition temperature may be 575°C or higher, and 2.75 kW may be applied as the plasma generation power.

By the fourth epitaxial deposition step S04, the (100) plane of the fourth layer 14, which is PZT having a cubic structure, can be deposited to be oriented in the <100> direction with respect to the (110) plane of the silicon substrate 10, the YSZ (100) plane of the first layer 11, the Pt (100) plane of the second layer 12, and the SrRuO₃ (100) plane of the third layer 13. The PZT (100) plane of the fourth layer 14 is not in-plane rotated with respect to the SrRuO₃ (100) plane of the third layer 13, the SrRuO₃ (100) plane of the second layer 12, the YSZ (100) plane of the first layer 11, and the (110) plane of the silicon substrate 10.

In the present embodiment, continuous in-situ deposition is performed within the manufacturing apparatus 1 from the first epitaxial deposition step S01 to the fourth epitaxial deposition step S04. Therefore, a PZT film having a tetragonal composition and a c-axis orientation can be obtained as the fourth layer 14. In the PZT film serving as the fourth layer 14, the piezoelectric constant e_{31, f} [C/m²] is 10.0 to 11.9, a dielectric loss is 1.0% to 1.8%, the relative permittivity ε is 200 to 375 [dimensionless], and a practical figure of merit (e_{31, f})²/ε [GPa] is approximately 33.9. The fourth layer 14 is formed as a PZT film by performing sputtering such that the PZT film is doped with lanthanum (La) and/or nickel (Ni) when depositing the crystallized PZT film. Accordingly, internal stress in the PZT film occurs on a compressive side of the PZT film rather than on a tensile side of the PZT film, thereby making it possible to suppress occurrence of cracks.

In the present embodiment, a PZT film having a tetragonal composition and a c-axis orientation can be obtained with reduced manufacturing cost by using the single manufacturing apparatus 1 without mixing different deposition methods such as a sputtering method and a vapor deposition method.

The multilayer structure 100 is suitably used, for example, in a piezoelectric element in which a PZT film having high piezoelectricity and high dielectric strength is formed on a CMOS substrate having aluminum wiring, and also in devices such as a gyroscope sensor and a PMUT.

Hereinafter, each layer of the multilayer structure 100 in the present embodiment will be verified.

In the method of manufacturing the multilayer structure 100, the YSZ layer is deposited on the silicon substrate, the Pt layer is deposited on the YSZ layer, the SrRuO₃ layer is deposited on the Pt layer, and the PZT layer is deposited on the SrRuO₃ layer. Conditions for laminating the multilayer structure 100 on the silicon substrate in this manner are as follows.
- Target YSZ composition: 12% Y₂O₃-88% ZrO₂, Deposition temperature: 700°C, Supply gas: 100% Ar, Film thickness: 30 nm
- Target: Pt, Deposition temperature: 600°C, Supply gas: 100% Ar gas, Film thickness: 100 nm
- Target SrRuO₃ composition: SrRuO₃, Deposition temperature: 600°C, Supply gas: O₂/(Ar+O₂) = 20%, Film thickness: 20 nm
- Target PZT composition: La,Ni-doped PZT, Deposition temperature: 625°C, Supply gas: O₂(Ar+O₂) = 2.5%, Film thickness: 2 µm
- The multilayer structure 100 formed under such conditions was analyzed by X-ray diffraction.

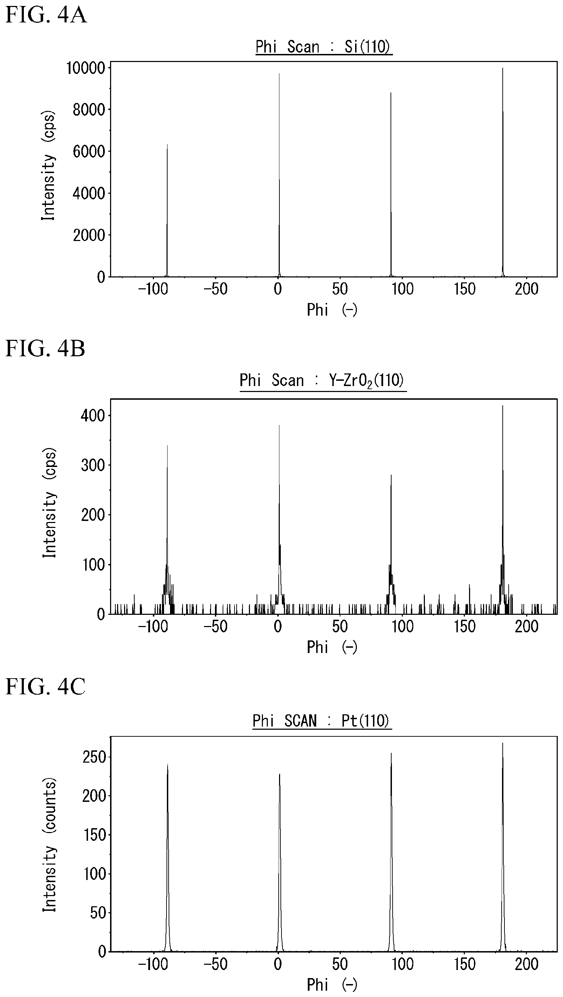

FIGS. 4A to 4C are diagrams showing X-ray diffraction peaks of the respective layers constituting the multilayer structure 100 according to the present embodiment. FIG. 4A shows four peaks of Si (110) obtained by ϕ-scan measurement for the silicon substrate 10. FIG. 4B shows four peaks of YSZ (110) obtained by ϕ-scan measurement for the first layer 11. FIG. 4C shows four peaks of Pt (110) obtained by ϕ-scan measurement for the second layer 12.

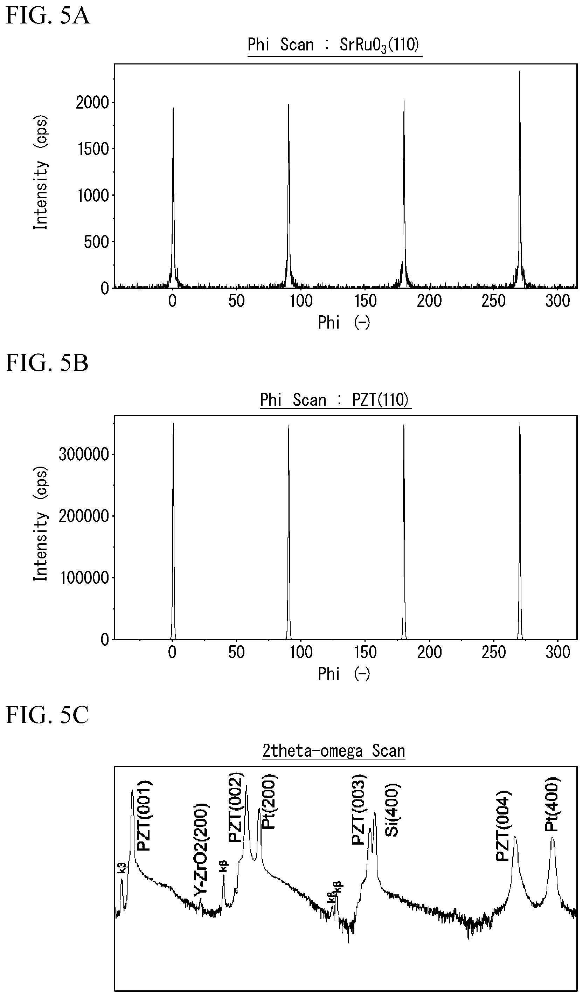

FIGS. 5A to 5C are diagrams showing X-ray diffraction peaks of the respective layers constituting the multilayer structure 100 according to the present embodiment. FIG. 5A shows four peaks of SrRuO₃ (110) obtained by ϕ-scan measurement for the third layer 13. FIG. 5B shows four peaks of PZT (110) obtained by ϕ-scan measurement for the fourth layer 14. FIG. 5C shows peaks obtained by a 2θ-ω scan measurement for PZT constituting the fourth layer 14.

In the multilayer structure 100 of the present embodiment, the four peaks of the silicon substrate 10 shown in FIG. 4A, the four peaks of the first layer 11 shown in FIG. 4B, the four peaks of the second layer 12 shown in FIG. 4C, the four peaks of the third layer 13 shown in FIG. 5A, and the four peaks of the fourth layer 14 shown in FIG. 5B coincide with each other.

Also, as is apparent from the result of the 2θ-ω scan measurement of the fourth layer 14, the PZT in the fourth layer 14 is found to be a c-axis oriented cubic crystal as shown in FIG. 5C.

Therefore, it is found that, in the multilayer structure 100 according to the present embodiment, all of the first layer 11 to the fourth layer 14 are cubic crystals and are oriented in the same plane orientation.

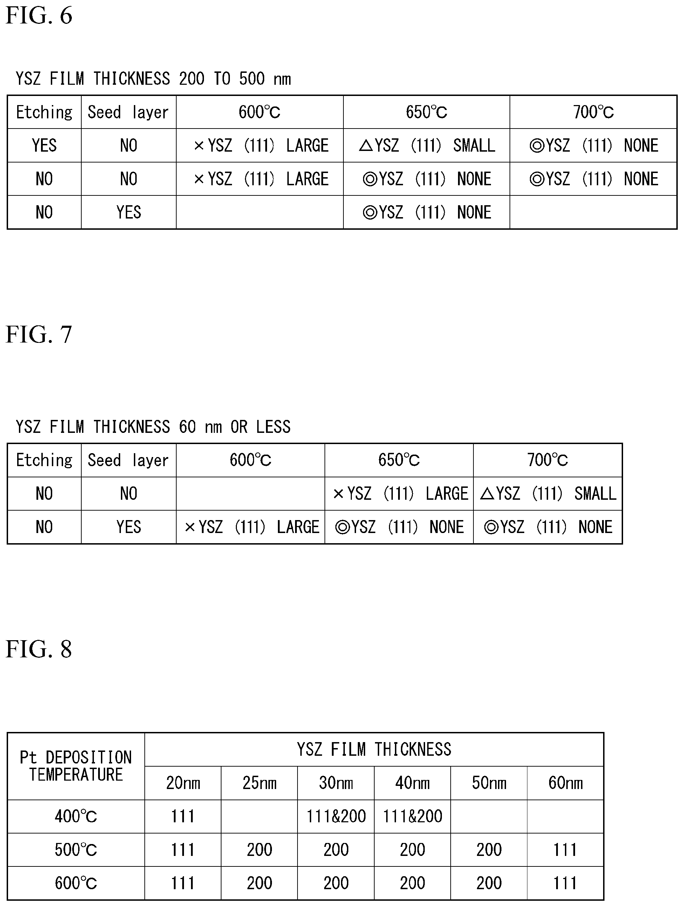

FIG. 6 is a diagram showing a relationship between a thickness of the YSZ layer and a presence or absence of a (111) side peak in X-ray diffraction in the multilayer structure according to the present embodiment.

FIG. 6 shows results for a case in which the thickness of the YSZ layer is 200 nm to 500 nm.

Deposition conditions for the YSZ layer deposited on the silicon substrate are as follows: Target YSZ composition; 12% Y₂O₃-88% ZrO₂, Deposition temperature; 700°C, Supply gas; 100% Ar, and Film thickness; 20 nm.

In this case, it is found that if etching, that is, removal of the native oxide film 10a on the surface of the silicon substrate 10, is performed and the deposition temperature is 600°C, side peaks other than (100) appear significantly. Also, it is found that when the native oxide film 10a is removed and the deposition temperature is 650°C, side peaks other than (100) appear to some extent. Furthermore, it is found that even when the native oxide film 10a is removed, no side peaks other than (100) appear at a deposition temperature of 700°C.

It is found that, when the YSZ layer has a thickness of 200 nm to 500 nm, if the YSZ layer is deposited at a deposition temperature of 600°C while leaving the native oxide film 10a on the surface of the silicon substrate 10 without performing etching, side peaks other than (100) appear significantly. Similarly, it is found that side peaks other than (100) do not appear at deposition temperatures of 650°C and 700°C.

It is found that, when the YSZ layer has a thickness of 200 nm to 500 nm, if the YSZ layer is deposited after depositing metallic zirconium as the seed layer 11a while leaving the native oxide film 10a on the surface of the silicon substrate 10 without performing etching, side peaks other than (100) do not appear at a deposition temperature of 650°C.

FIG. 7 is a diagram showing a relationship between a thickness of the YSZ layer and a presence or absence of a (111) side peak in X-ray diffraction in the multilayer structure according to the present embodiment.

FIG. 7 shows results for a case in which the thickness of the YSZ layer is 60 nm or less.

Deposition conditions for the YSZ layer deposited on the silicon substrate are as follows: Target YSZ composition; 12% Y₂O₃-88% ZrO₂, Deposition temperature; 700°C, and Supply gas; 100% Ar.

It is found that, if the YSZ layer is deposited at a deposition temperature of 650°C while leaving the native oxide film 10a on the surface of the silicon substrate 10 without performing etching, side peaks other than (100) appear significantly. Similarly, it is found that side peaks other than (100) appear to some extent at a deposition temperature of 700°C.

It is found that, when the YSZ layer has a thickness of 60 nm or less, if the YSZ layer is deposited after depositing metallic zirconium as the seed layer 11a, side peaks other than (100) do not appear at deposition temperatures of 650°C and 700°C.

FIG. 8 is a diagram showing a relationship among a thickness of the YSZ layer, a deposition temperature of the Pt layer, and an orientation direction of Pt in X-ray diffraction in the multilayer structure according to the present embodiment.

The Pt layer is deposited on the YSZ layer. Deposition conditions for the YSZ layer and the Pt layer at that time are as follows: Target YSZ composition; 12% Y₂O₃-88% ZrO₂, Deposition temperature; 700°C, and Supply gas; 100% Ar.

When the deposition temperature of the Pt layer is 500°C, a peak indicating (111) orientation appears when the thickness of the YSZ layer is 20 nm. When the deposition temperature of the Pt layer is 500°C, if the thickness of the YSZ layer is 30 nm, a peak indicating (200) orientation appears, that is, the layer is formed in a (100) orientation, but a peak indicating (111) orientation also appears simultaneously. If the deposition temperature of the Pt layer is 500°C, a peak indicating (111) orientation appears when the thickness of the YSZ layer is 60 nm.

However, if the deposition temperature of the Pt layer is 500°C, only a peak indicating (200) orientation appears when the thickness of the YSZ layer is 40 nm, and a peak indicating (111) orientation does not appear. That is, the Pt layer is oriented in the (100) plane.

Similarly, when the deposition temperature of the Pt layer is 600°C, a peak indicating (111) orientation appears when the thickness of the YSZ layer is 20 nm. When the deposition temperature of the Pt layer is 600°C, a peak indicating (200) orientation appears when the thickness of the YSZ layer is 30 nm, that is, the layer is formed in a (100) orientation, but a peak indicating (111) orientation also appears simultaneously. If the deposition temperature of the Pt layer is 600°C, a peak indicating (111) orientation appears when the thickness of the YSZ layer is 60 nm.

However, if the deposition temperature of the Pt layer is 600°C, only a peak indicating (200) orientation appears when the thickness of the YSZ layer is 40 nm, and a peak indicating (111) orientation does not appear. That is, it is found that the Pt layer is oriented in the (100) plane.

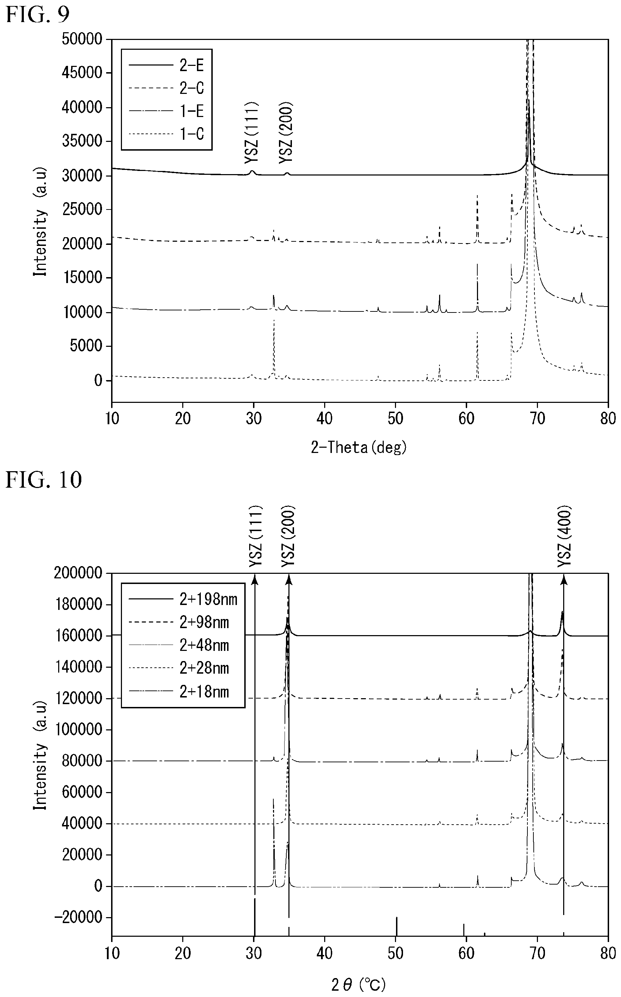

FIG. 9 is a diagram showing X-ray diffraction peaks of the YSZ layer.

On the (100) surface of the silicon substrate from which the native oxide film has not been removed, metallic Zr is epitaxially grown at 400°C as a seed layer. After being left in the atmosphere for one week, YSZ was epitaxially deposited to have a thickness of 50 nm. This was verified by X-ray diffraction (2θ).

As a result, as shown in FIG. 9, it was found that the YSZ was oriented not only in the (200) direction but also in the (111) direction.

This is considered to be because the YSZ was oxidized in air, resulting in the formation of (111) crystals. Therefore, it is found that YSZ does not exhibit overall (100) orientation merely by forming a seed layer.

Note that, in FIG. 9, 1-C denotes a wafer center position of Sample 1, and 1-E denotes a wafer edge position of Sample 1. 2-C denotes a wafer center position of Sample 2, and 2-E denotes a wafer edge position of Sample 2.

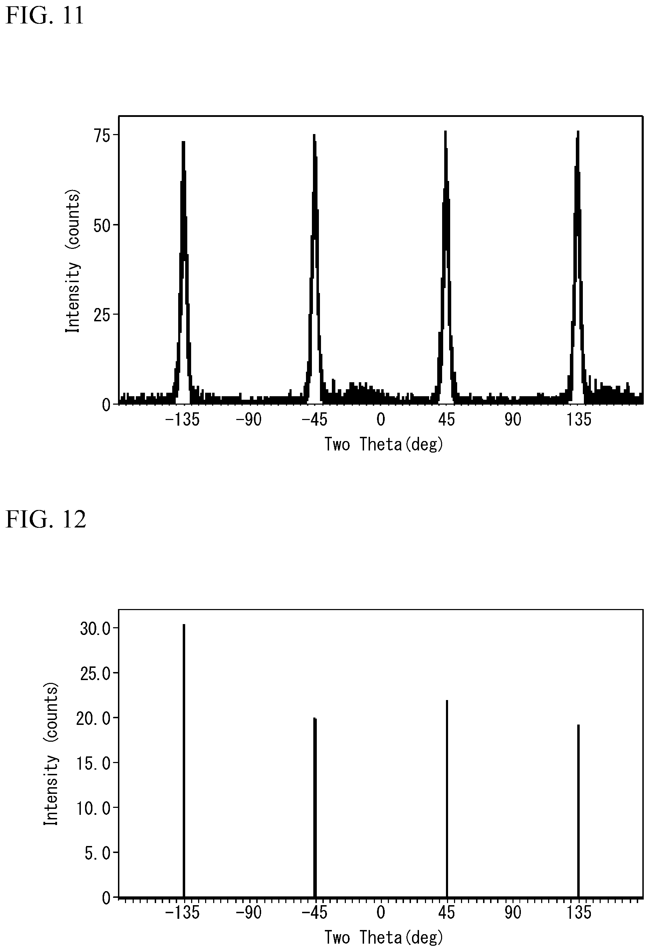

FIG. 10 is a diagram showing X-ray diffraction peaks of the YSZ layer in the multilayer structure according to the present embodiment. FIG. 11 is a diagram showing X-ray diffraction peaks of the YSZ layer shown in FIG. 10. FIG. 12 is a diagram showing X-ray diffraction peaks of the silicon substrate on which the YSZ layer shown in FIG. 10 is deposited.

Similarly, metallic Zr is epitaxially grown as a seed layer at 400°C on the (100) surface of the silicon substrate from which the native oxide film has not been removed. After being left in a vacuum for one week, YSZ was epitaxially deposited to have a thickness of 50 nm. Verification was performed by X-ray diffraction (2θ) and X-ray diffraction (ϕ).

As a result, as shown in FIG. 10, it was found that the YSZ exhibited a single (200) orientation. This is considered to be because the YSZ was not oxidized in air and no (111) crystal was formed. Therefore, it is found that an overall (100) single orientation is achieved by depositing the YSZ in situ after forming the seed layer.

Note that, in FIG. 10, 2+18 nm, 2+28 nm, 2+48 nm, 2+98 nm, and 2+198 nm respectively indicate a thickness of the seed layer (nm) + a thickness of YSZ (nm).

Also, it is found that, as shown in FIGS. 11 and 12, the (110) plane of the YSZ shows peaks that coincide with the (110) plane of the silicon substrate.

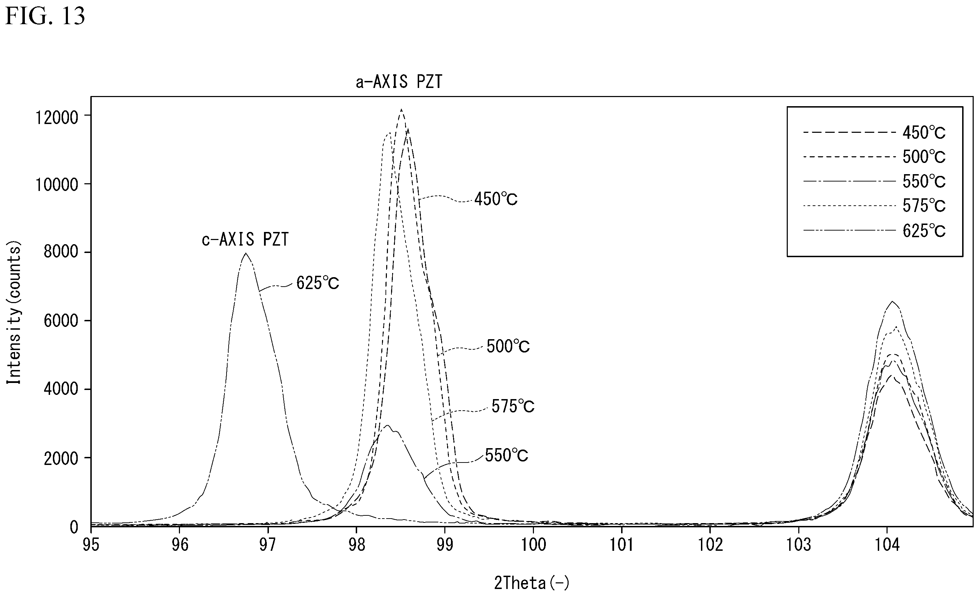

FIG. 13 is a diagram showing X-ray diffraction peaks of the PZT layer in the multilayer structure according to the present embodiment.

As a multilayer structure, a YSZ layer was deposited on a silicon substrate, a Pt layer was deposited on the YSZ layer, and a SrRuO₃ layer was deposited on the Pt layer. Deposition conditions at that time are the same as those in FIG. 4 and FIGS. 5A to 5C. Furthermore, the PZT layer was deposited on the SrRuO₃ layer, thereby obtaining the multilayer structure. In this case, a deposition temperature was varied from 450°C to 625°C, and each of the PZT layers was analyzed by X-ray diffraction. Also, when the deposition temperature was set to 575°C, a peak of the SrRuO₃ layer was at 98.2°.

As a result, as shown in FIG. 13, it was observed that the peak of the PZT layer shifted to a lower-angle side as the deposition temperature increased. Also, it was found that the c-axis of the PZT layer could be confirmed when the deposition temperature was increased to 625°C.

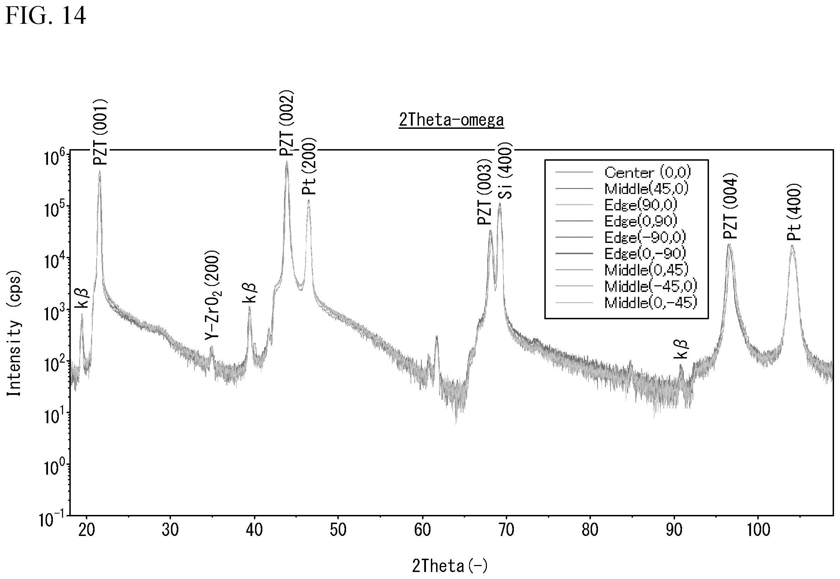

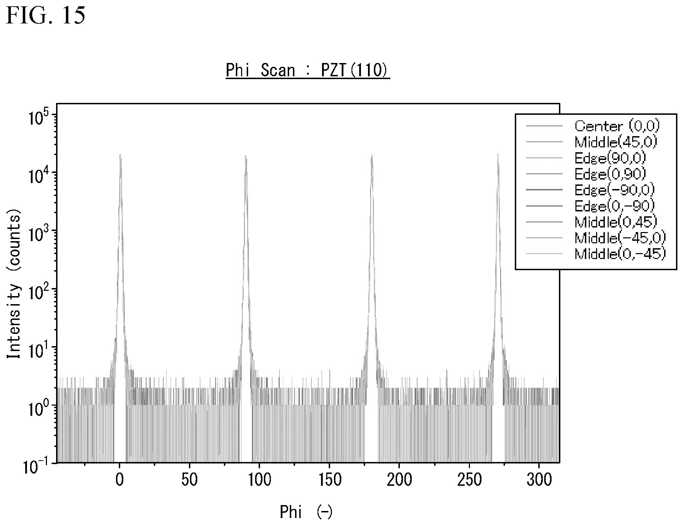

FIG. 14 is a diagram showing X-ray diffraction peaks (2θ-ω) of the PZT layer in the multilayer structure according to the present embodiment. FIG. 15 is a diagram showing X-ray diffraction peaks (ϕ-scan) of the PZT layer shown in FIG. 14.

In the same manner as the PZT layer of FIG. 13, a PZT layer was formed on a silicon substrate of an 8-inch wafer as a multilayer structure, and an in-plane distribution thereof was observed.

As a result, as shown in FIGS. 14 and 15, it is found that the YSZ layer, the Pt layer, the SrRuO₃ layer, and the PZT layer are all oriented in the (100) plane and are formed substantially uniformly across the wafer surface.

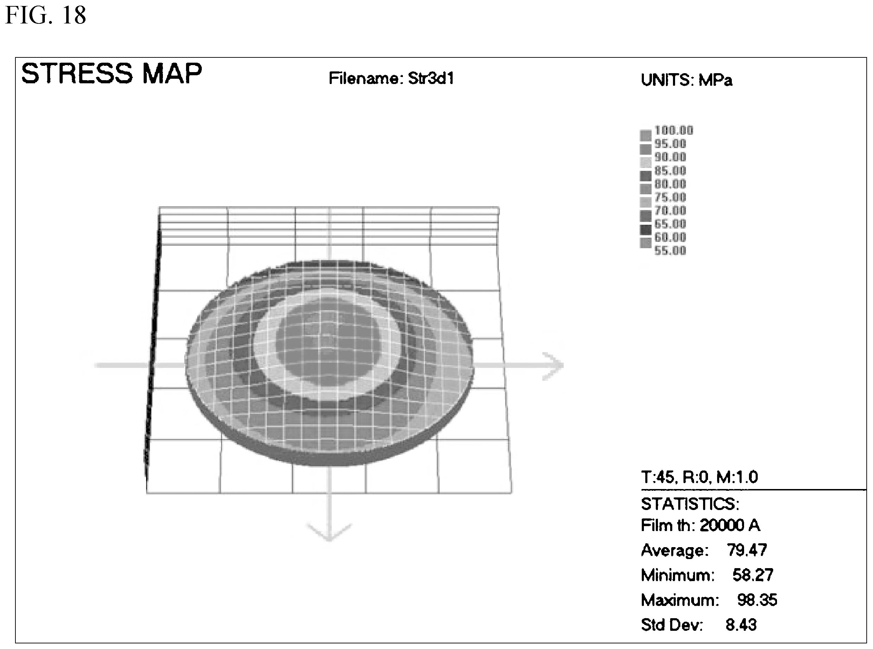

FIG. 18 is a diagram showing an internal stress distribution of the PZT layer in the multilayer structure according to the present embodiment.

Similarly, a YSZ layer, a Pt layer, a SrRuO₃ layer, and a PZT layer were deposited on a silicon substrate as a multilayer structure, and an internal stress in the PZT layer was measured. At this time, La and Ni were each doped into the PZT layer at 3 at%. The results are shown in FIG. 18.

Here, measurement of the internal stress was performed using a thin-film stress measurement device FLX-2320-R, manufactured by Toho Technology Co., Ltd.

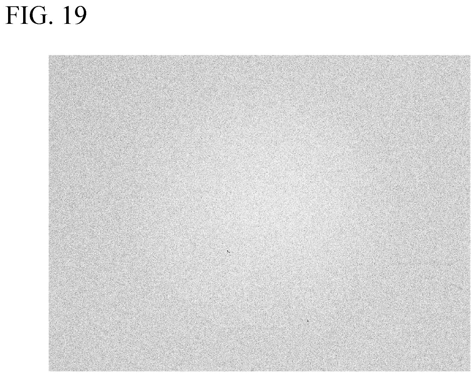

Also, a surface of the PZT layer was observed using a microscope to confirm a presence or absence of cracks. The results are shown in FIG. 19.

As a result, it was found that no cracks occurred in the PZT film, and an average value of the internal stress in the PZT layer was +80 MPa. Here, the plus sign of the internal stress value means that the internal stress is on a tensile side, that is, applied in a tensile direction.

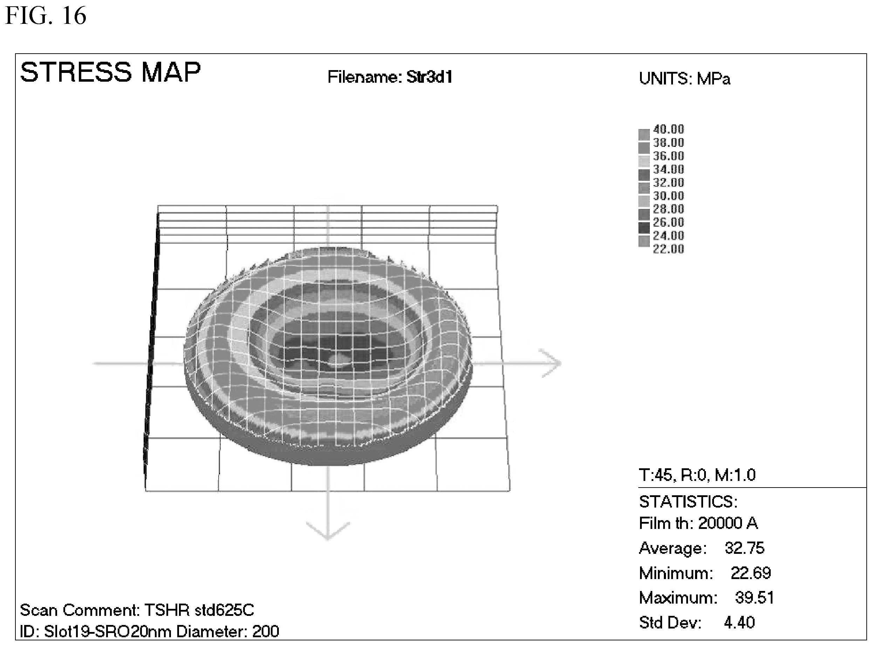

FIG. 16 is a diagram showing an internal stress distribution of the PZT layer.

For comparison, a PZT layer not doped with La and Ni was fabricated in the same manner, and an internal stress in the PZT layer was measured. The results are shown in FIG. 16.

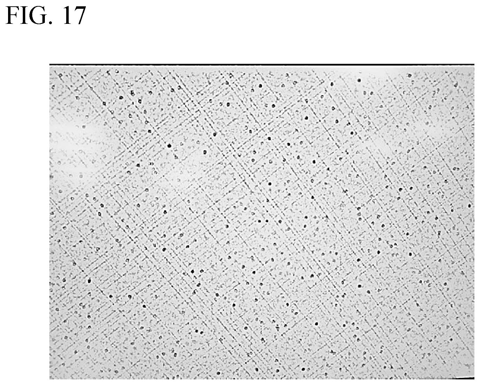

Also, a surface of the undoped PZT layer was observed using a microscope to confirm a presence or absence of cracks. The results are shown in FIG. 17.

As a result, it was found that cracks occurred in the undoped PZT layer, and the stress was released by the cracks, resulting in an average internal stress value of +32 MPa. Here, the plus sign of the internal stress value means that the internal stress is on a tensile side, that is, applied in a tensile direction.

Note that, FIG. 17 shows an image with cracks in the undoped case. FIG. 19 shows an image without cracks in the doped case. FIG. 16 shows a stress with cracks in the undoped case. FIG. 18 shows a stress without cracks in the doped case. When cracks occur, a dielectric strength decreases significantly, which is not preferable.

From the results shown in FIGS. 18 and 19, it is found that, by doping in a predetermined amount, the internal stress of the PZT layer can be shifted further toward the compressive side, thereby releasing the tensile stress and preventing the occurrence of cracks.

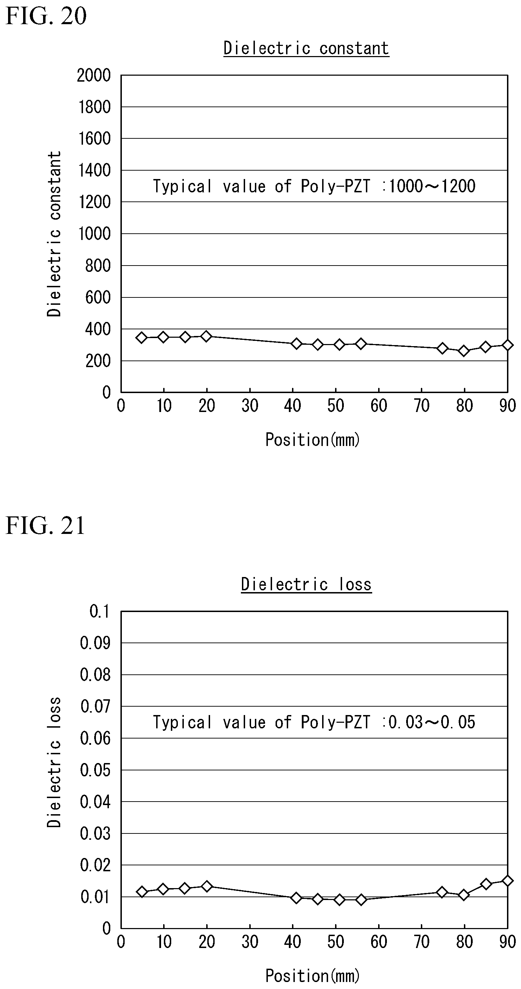

FIG. 20 is a diagram showing a relative permittivity of the PZT layer in the multilayer structure according to the present embodiment. Similarly, as a multilayer structure, a YSZ layer, a Pt layer, a SrRuO₃ layer, and a PZT layer were deposited on a silicon substrate, and a relative permittivity of the PZT layer was measured. The results are shown in FIG. 20. Here, the relative permittivity was measured using an LCR meter 4284A, manufactured by Agilent Technologies, after forming an MIM structure. Also, in FIG. 20, the horizontal axis (position) represents a radial position of a ϕ200 mm wafer.

From the results shown in FIG. 20, it is found that the relative permittivity ε of the PZT layer in the multilayer structure according to the present embodiment is 200 to 375 [dimensionless]. In contrast, it is found that polycrystalline PZT deposited by a sputtering method has a relative permittivity of 1000 to 1200. It is found that the permittivity can be lowered in the PZT layer in the multilayer structure of the present invention.

FIG. 21 is a diagram showing a dielectric loss of the PZT layer in the multilayer structure according to the present embodiment. Similarly, as a multilayer structure, a YSZ layer, a Pt layer, a SrRuO₃ layer, and a PZT layer were deposited on a silicon substrate, and a dielectric loss of the PZT layer was measured. The results are shown in FIG. 21. Here, the dielectric loss was measured using an LCR meter 4284A, manufactured by Agilent Technologies, after forming an MIM structure. Also, in FIG. 21, the horizontal axis (position) represents a radial position of a ϕ200 mm wafer.

From the results shown in FIG. 21, it is found that the dielectric loss of the PZT layer in the multilayer structure according to the present embodiment is 1% to 1.8%. In contrast, it is known that polycrystalline PZT deposited by a vapor deposition method has a dielectric loss of 3% to 5%. It is found that the dielectric loss can be lowered in the PZT layer of the multilayer structure according to the present embodiment.

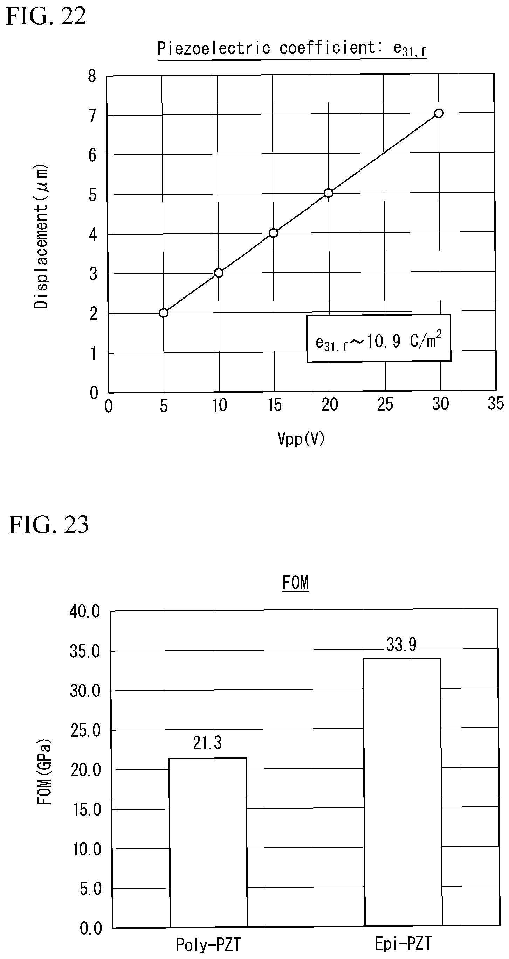

FIG. 22 is a diagram showing the piezoelectric constant e_{31, f} of the PZT layer in the multilayer structure according to the present embodiment.

Similarly, as a multilayer structure, a YSZ layer, a Pt layer, a SrRuO₃ layer, and a PZT layer were deposited on a silicon substrate, and the piezoelectric constant e_{31, f} of the PZT layer was measured. The results are shown in FIG. 22.

Here, the piezoelectric constant e_{31, f} was measured by inverse piezoelectric measurement using a laser Doppler after a cantilever is fabricated. Furthermore, in FIG. 22, the vertical axis represents a displacement of the cantilever, and the horizontal axis represents an applied AC voltage.

From the results shown in FIG. 22, it is found that the piezoelectric constant e_{31, f} of the PZT layer in the multilayer structure according to the present embodiment is 10.0 to 11.9 [C/m²], or approximately 10.9 [C/m²]. Although the piezoelectric constant decreases, the relative permittivity also decreases, which leads to an increase in a figure of merit for sensor applications.

FIG. 23 is a diagram showing a figure of merit of the PZT layer in the multilayer structure according to the present embodiment. Similarly, as a multilayer structure, a YSZ layer, a Pt layer, a SrRuO₃ layer, and a PZT layer were deposited on a silicon substrate, and the figure of merit (e_{31, f})²/εof the PZT layer was measured. The results are shown in FIG. 23.

Here, the figure of merit (e_{31, f})²/ε was calculated from the measurement results of e₃₁ and the relative permittivity. Also, in FIG. 22, the vertical axis represents a displacement of the cantilever, and the horizontal axis represents an applied AC voltage.

From the results shown in FIG. 23, it is found that the figure of merit (FOM) (e_{31, f})²/ε of the PZT layer in the multilayer structure according to the present embodiment is 10.0 to 11.9 [GPa], or approximately 33.9 [GPa]. In contrast, in polycrystalline PZT deposited by a sputtering method, it is known that the figure of merit (e_{31, f})²/ε is approximately 21.3 [GPa]. It is found that the figure of merit (e_{31, f})²/ε can be increased in the PZT layer of the multilayer structure according to the present embodiment.

Furthermore, in the present embodiment, it is possible to achieve an effect of reducing dielectric loss to 1 to 1.8%.

Hereinafter, a multilayer structure and a method of manufacturing the same according to a second embodiment of the present invention will be described on the basis of the drawings. In the present embodiment, a difference from the above-described first embodiment lies in a third layer, and components corresponding to those of the above-described first embodiment other than this are denoted by the same reference numerals and description thereof is omitted.

In the present embodiment, a third layer 13 is a lanthanum nickel oxide (LaNiO₃) film. The third layer 13 is deposited on a second layer 12. The third layer 13 is a buffer layer. The third layer 13 is a buffer layer. The third layer 13 is oriented in the (100) plane with respect to the (100) plane of the second layer 12. The (100) plane of the third layer 13 is oriented parallel to the Pt (100) plane. The (100) plane of the third layer 13 has the same orientation as the (100) planes of a silicon substrate 10, a first layer 11, and the second layer 12. A lattice constant of LaNiO₃ is 3.857 angstroms.

In the present embodiment, a third epitaxial deposition step S03 epitaxially deposits the third layer 13 on the second layer 12.

The third epitaxial deposition step S03 is performed, for example, in the third deposition chamber 4C of FIG. 3. In this case, in the third deposition chamber 4C, a target 42a has a composition that enables epitaxial deposition of the third layer 13. In this case, the target 42a may be a single target made of lanthanum nickelate (LaNiO₃). Alternatively, the lanthanum nickelate may be deposited using a plurality of targets. Also, in this case, in the third deposition chamber 4C, a gas atmosphere adjustment mechanism 43 sets a gas atmosphere and a pressure range required for deposition conditions. At the same time, a deposition mechanism 42 sets required deposition power. Also, a substrate holding mechanism 41 sets a required deposition temperature and bias power. Regarding Pt deposition conditions in this case, LaNiO₃ may be used as the target, O₂(Ar+O₂) = 60% may be used as a supply gas, a gas partial pressure may be 0.5 Pa, and plasma generation power may be 0.5 kW.

In the present embodiment, the third epitaxial deposition step S03 forms the buffer layer 13 made of LaNiO₃ by sputtering. The buffer layer 13 can be formed by a pulse-DC sputtering method. Here, using the LaNiO₃ target as the sputtering target 42a, a temperature of the silicon substrate 10 can be set to approximately 550°C or higher during the pulse sputtering (frequency: 50 kHz, off-time: 5 µsec) in argon gas serving as a sputtering gas. For example, the temperature can be set to 525°C to 725°C.

Note that, a thickness of the buffer layer 13 made of LaNiO₃ can be set to 100 nm or less. If the thickness of the buffer layer 6 made of LaNiO₃ exceeds 100 nm, a film having a perovskite single-phase structure may not be formed.

Note that, the thickness of the third layer 13 is preferably approximately 20 nm, or in a range of 15 nm to 25 nm.

Furthermore, in the present embodiment, a PZT layer as a fourth layer 14 can be formed by an RF sputtering method.

In a fourth epitaxial growing step S04, a PZT target doped with a metal containing nickel (Ni) may be used as a sputtering target. Here, examples of the metal containing nickel (Ni) include nickel and a lanthanum-nickel alloy (LaNi₅). That is, a PZT target doped with nickel or a PZT target doped with a lanthanum-nickel alloy can be used. A doping amount is preferably set to 0.1 at% or more and 5 at% or less relative to 100 at% of PZT, more preferably 0.5 at% or more and 5 at% or less relative to 100 at% of PZT, and still more preferably 1 at% or more and 3 at% or less relative to 100 at% of PZT.

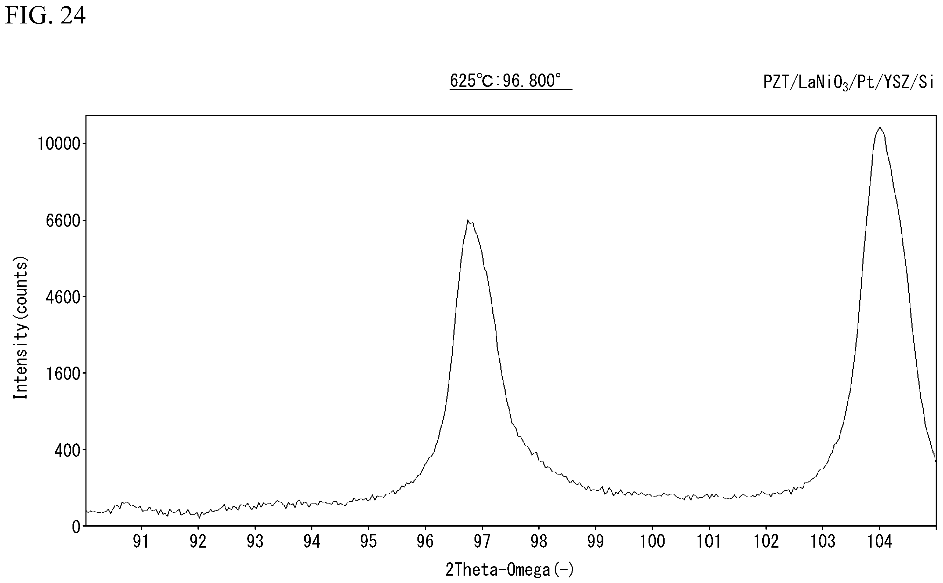

FIG. 24 is a diagram showing X-ray diffraction peaks of the PZT layer in the multilayer structure according to the present embodiment.

As a multilayer structure, a YSZ layer was deposited on a silicon substrate, a Pt layer was deposited on the YSZ layer, and a LaNiO₃ layer was deposited on the Pt layer. Deposition conditions other than those for the LaNiO₃ layer are the same as the deposition conditions in the first embodiment shown in FIG. 4 and FIGS. 5A to 5C. Furthermore, a PZT layer was deposited on the LaNiO₃ layer to obtain the multilayer structure. In this case, when a deposition temperature was set to 625°C, a peak of PZT (004) obtained by X-ray diffraction is at 96.800°.

As a result, as shown in FIG. 24, it was found that when the LaNiO₃ layer is used as the third layer, the c-axis of the PZT layer could be confirmed at a deposition temperature of 625°C similarly to the SrRuO₃ layer shown in FIG. 13.

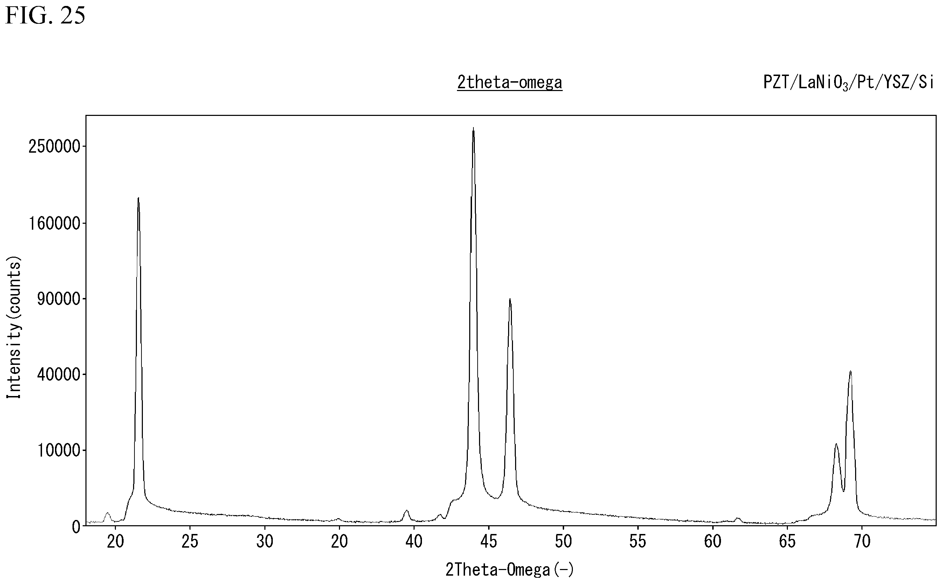

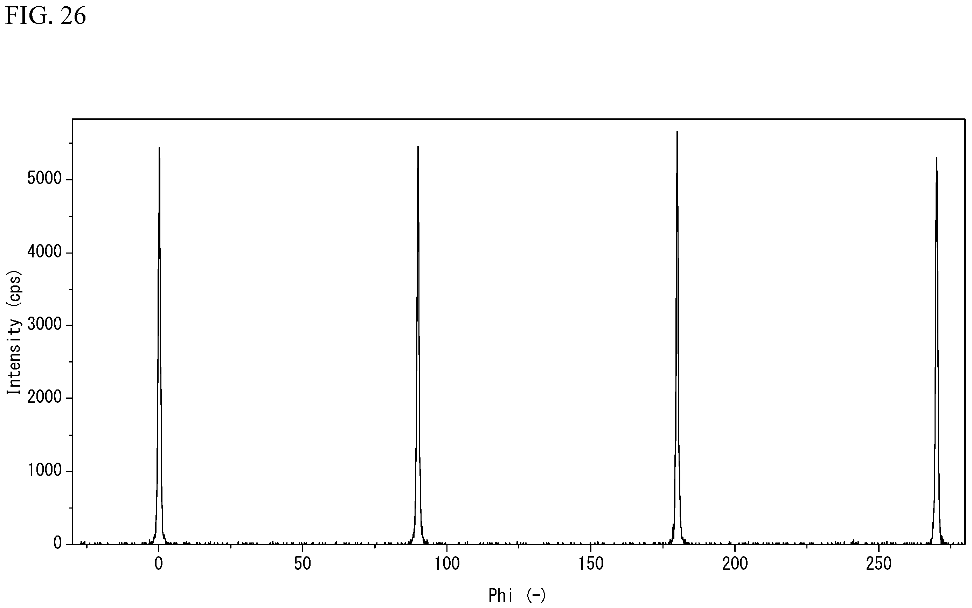

FIG. 25 is a diagram showing X-ray diffraction peaks (2θ-ω) of the PZT layer in the multilayer structure according to the present embodiment. FIG. 26 is a diagram showing X-ray diffraction peaks (ϕ-scan) of the PZT layer of FIG. 25.

Similarly to the PZT layer in FIG. 24, a PZT layer was formed on a silicon substrate as a multilayer structure, and an in-plane distribution thereof was observed.

As a result, as shown in FIGS. 25 and 26, it is found that the YSZ layer, the Pt layer, the LaNiO₃ layer, and the PZT layer are all oriented in the (100) plane and have epitaxially grown.

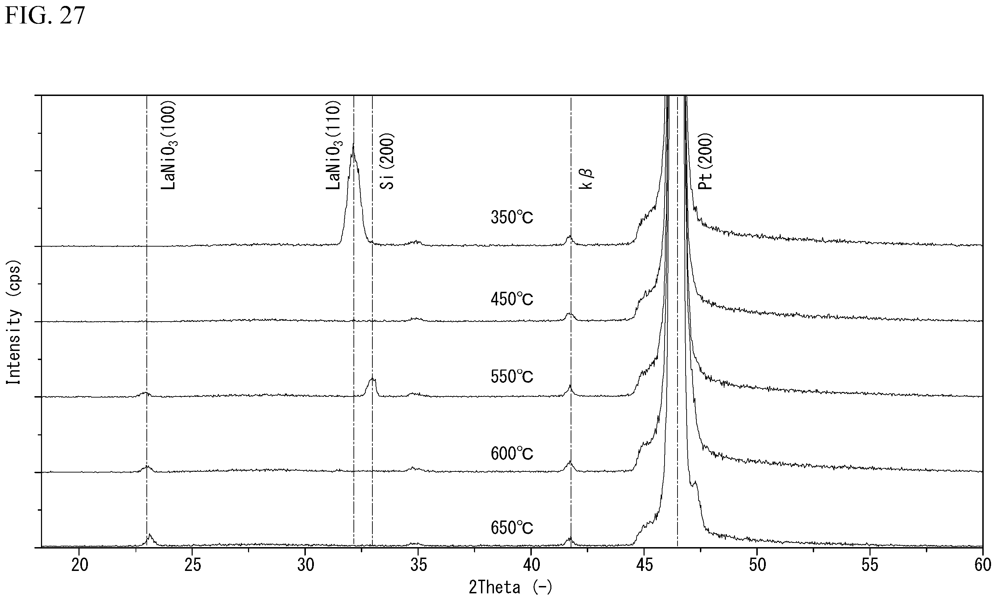

FIG. 27 is a diagram obtained by analyzing, by X-ray diffraction, changes in the PZT layer due to changes in deposition temperature in the multilayer structure according to the present embodiment. It is a diagram showing X-ray diffraction peaks (20).

As a multilayer structure, a YSZ layer was deposited on a silicon substrate, a Pt layer was deposited on the YSZ layer, and a LaNiO₃ layer was deposited on the Pt layer. Deposition conditions other than those for the LaNiO₃ layer are the same as the deposition conditions shown in FIG. 24. Furthermore, a PZT layer was deposited on the LaNiO₃ layer to obtain the multilayer structure. In this case, a deposition temperature of the LaNiO₃ layer was varied from 350°C to 650°C, and results of analyzing each PZT layer by X-ray diffraction are shown in FIG. 27. Here, at a deposition temperature of 350°C, a side peak of LaNiO₃ (110) was observed.

From the X-ray diffraction results, it is found that a (100) peak appears in the LaNiO₃ layer when the substrate temperature is 550°C or higher.

In the present embodiment, effects equivalent to those of the above-described embodiment can be achieved.

Furthermore, the present embodiment provides an effect in that the same buffer layer can be used for both poly-PZT and epi-PZT.

In the present invention, the following can be implemented.
[1] In a sputtering method, Y-doped ZrO₂ (YSZ) is required to stabilize ZrO₂ in a cubic phase.
[2] It was found that either A or B below may be used to achieve (epitaxial growth) of YSZ.
[2A] Silicon surface etching => YSZ (700°C or higher).
[2B] With native oxide film present => YSZ (650°C or higher).
[3] However, when YSZ is a thin film of 60 nm or less, a side peak of YSZ (111) is detected with the above-described methods A and B.
[4] In order to achieve (100) single orientation of YSZ when the thickness of YSZ is 60 nm or less.
[4C] it was found that the process must be: native oxide film => seed layer (Zr) => YSZ (650°C or higher).
[5] An optimum thickness of the seed layer is 2 nm (tests were conducted at 1.5 nm, 2 nm, 3 nm, and 5 nm).
[6] As for a deposition temperature of the seed layer, YSZ (111) is detected at room temperature. 400°C is the best known method (BKM).
[7] Since YSZ (111) is detected in the process of seed layer => exposure to the atmosphere => YSZ deposition, in-situ processing is essential.
[8] For Pt to be single-oriented in the (100) direction and for Pt <100> to epitaxially grow in parallel with Si <100>, the YSZ must be thinner than 60 nm.

That is, it is necessary to deposit YSZ by the method [4C]. Furthermore, the YSZ needs to be thicker than 20 nm and thinner than 60 nm. When YSZ is 20 nm or 60 nm, Pt grows on the Pt (111) plane (TEM data).
[9] For Pt to be epitaxially grown with a single (100) orientation, a deposition temperature of Pt must be higher than 500°C.
[10] There are optimum conditions for the SRO buffer layer. A thickness thereof also has an influence, and 20 nm is the BKM.
[11] When PZT is epitaxially grown under undoped conditions, cracks occur due to a large tensile stress. In contrast, deposition by RF sputtering with La and Ni doping can reduce a film stress in PZT and can deposit a crack-free epitaxial film. In order to achieve epitaxial growth of the PZT film along the c-axis, a deposition temperature higher than 575°C is required.

As described above, a fully in-situ process is possible using sputtering.

Furthermore, in the present invention, individual configurations in the above-described embodiments may be individually selected and implemented in combination with one another.

### [Industrial applicability]

Application examples of the present invention include application to devices such as inkjet heads, micromirrors, gyro sensors, piezoelectric micromachined ultrasonic transducers (PMUTs), vibration elements, acoustic wave elements, and acceleration sensors in microelectromechanical systems (MEMS) technologies.

### REFERENCE NUMERALS LIST

100 Multilayer structure
10 Silicon substrate
10a Native oxide film
11 First layer (YSZ)
12 Second layer (Pt)
13 Third layer (buffer layer)
14 Fourth layer (PZT)
11a Seed layer

## Claims

1. A method of manufacturing a multilayer structure, comprising:
a first epitaxial deposition step of forming, by sputtering, a first layer oriented in the (100) plane on the (100) surface of a silicon substrate;
a second epitaxial deposition step of forming, by sputtering, a second layer of Pt oriented in the (100) plane on the first layer; and
a third epitaxial deposition step of forming, by sputtering, a third layer oriented in the (100) plane on the second layer, wherein
the first epitaxial deposition step is any one of:
a step of etching a surface of the silicon substrate and a step of depositing YSZ as the first layer at a temperature of 700°C or higher to have a thickness of 200 nm to 500 nm;
a step of depositing YSZ as the first layer at a temperature of 650°C or higher to have a thickness of 200 nm to 500 nm without removing silicon oxide on the surface of the silicon substrate;
a step of depositing a Zr seed layer at a temperature of 400°C or higher to have a thickness of 1.5 nm to 3.5 nm without removing silicon oxide on the surface of the silicon substrate and a step of depositing YSZ as the first layer on the seed layer at a temperature of 650°C or higher to have a thickness of 200 nm to 500 nm; or
a step of depositing a Zr seed layer at a temperature of 400°C or higher to have a thickness of 1.5 nm to 3.5 nm without removing silicon oxide on the surface of the silicon substrate and a step of depositing YSZ as the first layer on the seed layer at a temperature of 650°C or higher to have a thickness of 18 nm to 67 nm.

2. A method of manufacturing a multilayer structure comprising:
a first epitaxial deposition step of forming, by sputtering, a first layer oriented in the (100) plane on the (100) surface of a silicon substrate;
a second epitaxial deposition step of forming, by sputtering, a second layer of Pt oriented in the (100) plane on the first layer; and
a third epitaxial deposition step of forming, by sputtering, a third layer oriented in the (100) plane on the second layer, wherein
the first epitaxial deposition step includes depositing YSZ as the first layer to have a thickness of 25 nm to 50 nm, and
the second epitaxial deposition step includes a step of depositing Pt as the second layer at a temperature of 500°C or higher.

3. The method of manufacturing a multilayer structure according to claim 1 or 2, wherein
the third layer in the third epitaxial deposition step is SrRuO₃ or LaNiO₃.

4. The method of manufacturing a multilayer structure according to claim 1 or 2, further comprising a fourth epitaxial deposition step of forming, by sputtering, a PZT layer oriented in the (100) plane on the third layer after the third epitaxial deposition step.

5. The method of manufacturing a multilayer structure according to claim 4, wherein
the PZT layer is doped with lanthanum and nickel in the fourth epitaxial deposition step.
